# EUROPEAN PATENT APPLICATION

(11) **EP 4 734 720 A1**
(43) Date of publication of application: **29.04.2026**
(21) Application number: 24867288.3
(22) Date of filing: 02.09.2024
(51) Int. Cl.: H10K 59/12, G02F 1/1343

(54) **METHOD FOR PREPARING ANTI-PEEPING DISPLAY SCREEN, ANTI-PEEPING DISPLAY SCREEN, DEVICE, AND ANTI-PEEPING METHOD**

(30) Priority: 18.09.2023 CN 202311208881
(71) Applicant: Honor Device Co., Ltd., Shenzhen, Guangdong 518040 (CN)
(72) Inventor: LI, Jia, Shenzhen, Guangdong 518040 (CN); YU, Junyi, Shenzhen, Guangdong 518040 (CN); SONG, Lianyan, Shenzhen, Guangdong 518040 (CN); TIAN, Zheng, Shenzhen, Guangdong 518040 (CN)
(74) Representative: Gill Jennings & Every LLP
(86) International application number: PCT/CN2024/116414
(87) International publication number: WO 2025/060876

(57) **Abstract**

Embodiments of this application provide a method for preparing an anti-peeping display, an anti-peeping display, a device, and an anti-peeping method. In embodiments of this application, a light-transmitting material layer is formed on a light-emitting side of a display module, where the display module includes a substrate and a plurality of pixel units arranged in an array on the substrate; the light-transmitting material layer is patterned, to form a plurality of light-transmitting island structures arranged in an array on the light-emitting side of the display module, where the plurality of light-transmitting island structures are in a one-to-one correspondence with the plurality of pixel units, and an orthographic projection of the light-transmitting island structure on the substrate coincides with an orthographic projection, of a pixel unit corresponding to the light-transmitting island structure, on the substrate; and an electrochromic material is filled in a gap between the plurality of light-transmitting island structures arranged in the array, to form an electrochromic layer, where the plurality of light-transmitting island structures are located in the electrochromic layer, and transmittance of the electrochromic layer changes in response to a voltage applied to the electrochromic layer. According to the technical solutions provided in embodiments of this application, better anti-peeping performance can be achieved, and an anti-peeping structure is of small thickness and thus has little impact on display brightness.

## Description

### CROSS-REFERENCE TO RELATED APPLICATIONS

This application claims priority to Chinese Patent Application No. 2023112088811, filed on September 18, 2023 and entitled "METHOD FOR PREPARING ANTI-PEEPING DISPLAY, ANTI-PEEPING DISPLAY, DEVICE, AND ANTI-PEEPING METHOD", which is incorporated herein by reference in its entirety.

### TECHNICAL FIELD

This application relates to the field of display technologies, and in particular, to a method for preparing an anti-peeping display, an anti-peeping display, a device, and an anti-peeping method.

### BACKGROUND

With the development of science and technology, electronic products with displays, such as mobile phones and computers, are increasingly widely used. Generally, the electronic product has a wide viewing angle, allowing users from different viewing angles to learn information displayed by the electronic product. However, users are becoming more conscious of privacy protection. To satisfy an anti-peeping requirement of a user during use of a display-type electronic product, an anti-peeping film may be applied to a display of the display-type electronic product in conventional technologies. The anti-peeping film can eliminate large-angle light and retain only small-angle light that is transmitted nearly perpendicularly from the display, preventing users at large viewing angles from receiving an image displayed on the display.

However, the anti-peeping film is generally of relatively large thickness. This increases a thickness of the terminal device, and reduces display brightness of the display at a perpendicular viewing angle, leading to higher power consumption of the electronic product.

### SUMMARY

A plurality of aspects of this application provide a method for preparing an anti-peeping display, an anti-peeping display, a device, and an anti-peeping method, so that better anti-peeping performance can be achieved, and an anti-peeping structure is of small thickness and thus has little impact on display brightness.

According to a first aspect, this application provides a method for preparing an anti-peeping display, including:
forming a light-transmitting material layer on a light-emitting side of a display module, where the display module includes a substrate and a plurality of pixel units arranged in an array on the substrate;
patterning the light-transmitting material layer, to form a plurality of light-transmitting island structures arranged in an array on the light-emitting side of the display module, where the plurality of light-transmitting island structures are in a one-to-one correspondence with the plurality of pixel units, and an orthographic projection of the light-transmitting island structure on the substrate coincides with an orthographic projection, of a pixel unit corresponding to the light-transmitting island structure, on the substrate; and
filling an electrochromic material in a gap between the plurality of light-transmitting island structures arranged in the array, to form an electrochromic layer, where the plurality of light-transmitting island structures are located in the electrochromic layer, and transmittance of the electrochromic layer changes in response to a voltage applied to the electrochromic layer.

In the anti-peeping display prepared by the preparation method provided in embodiments of this application, the light-transmitting island structure above the pixel unit may allow small-angle light emitted by the pixel unit to pass through, and the voltage applied to the electrochromic layer is controlled to change the transmittance of the electrochromic layer, so that the electrochromic layer can allow large-angle light emitted by the pixel unit to pass through, or absorb or reflect large-angle light emitted by the pixel unit. In this way, the anti-peeping display can switch between a shared display state and an anti-peeping display state. In addition, the entire anti-peeping structure is of small thickness, which can reduce impact on display brightness of the display. Furthermore, in this solution, the plurality of light-transmitting island structures arranged in the array are first formed through a patterning process, and the electrochromic material is then filled in the gap between the plurality of light-transmitting island structures arranged in the array, to form the electrochromic layer. In other words, there is no need to perform a patterning process on the electrochromic layer in this solution. This can prevent the patterning process from affecting electrochromic performance of the electrochromic layer, thereby ensuring better anti-peeping performance.

In a possible implementation, the method further includes:
forming a first light-transmitting conductive layer on the light-emitting side of the display module before forming the light-transmitting material layer, where the light-transmitting material layer is formed on the first light-transmitting conductive layer; and
forming a second light-transmitting conductive layer on the electrochromic layer, where
the transmittance of the electrochromic layer changes in response to a voltage between the first light-transmitting conductive layer and the second light-transmitting conductive layer.

In a possible implementation, when the first light-transmitting conductive layer is used as an anode, the electrochromic material is an anodic electrochromic material; or
when the first light-transmitting conductive layer is used as a cathode, the electrochromic material is a cathodic electrochromic material.

In a possible implementation, the method further includes:
forming a light-transmitting raised layer on the light-emitting side of the display module before forming the light-transmitting material layer.

In a possible implementation, a numerical relationship between a thickness of the light-transmitting raised layer and a pixel width of the pixel unit is determined by a preset anti-peeping angle.

In a possible implementation, the forming a light-transmitting raised layer on the light-emitting side of the display module before forming the light-transmitting material layer includes:
forming a low-refractive-index material sublayer on the light-emitting side of the display module before forming the light-transmitting material layer;
patterning the low-refractive-index material sublayer, to form a plurality of first openings arranged in an array in the low-refractive-index material sublayer, where the plurality of first openings are in a one-to-one correspondence with the plurality of pixel units, and an orthographic projection of the first opening on the substrate covers an orthographic projection, of a pixel unit corresponding to the first opening, on the substrate; and
forming a high-refractive-index material sublayer on the patterned low-refractive-index material sublayer, where the light-transmitting raised layer consists of the patterned low-refractive-index material sublayer and the high-refractive-index material sublayer.

In a possible implementation, the display module is an organic light-emitting diode OLED display module; and
the OLED display module further includes a first encapsulation layer that covers the plurality of pixel units.

In a possible implementation, the substrate is a flexible substrate, and the method further includes:
forming the display module on a glass carrier plate, where the flexible substrate is located on the glass substrate; and
after preparation of each layer for the anti-peeping display is completed, peeling off the peeling carrier plate through a peeling process, to expose the flexible substrate.

In a possible implementation, the filling an electrochromic material in a gap between the plurality of light-transmitting island structures arranged in the array includes:
filling, through a coating process or a printing process, the electrochromic material in the gap between the plurality of light-transmitting island structures arranged in the array.

In a possible implementation, the method further includes:
after the electrochromic layer is formed, forming a second encapsulation layer on the light-emitting side of the display module; and
forming a touch layer on the second encapsulation layer.

According to a second aspect, this application provides an anti-peeping display, where the anti-peeping display is prepared by the preparation method according to any one of the foregoing items.

In the anti-peeping display prepared by the preparation method provided in embodiments of this application, a light-transmitting island structure above a pixel unit may allow small-angle light emitted by the pixel unit to pass through, and a voltage applied to an electrochromic layer is controlled to change transmittance of the electrochromic layer, so that the electrochromic layer can allow large-angle light emitted by the pixel unit to pass through, or absorb or reflect large-angle light emitted by the pixel unit. In this way, the anti-peeping display can switch between a shared display state and an anti-peeping display state. In addition, the entire anti-peeping structure is of small thickness, which can reduce impact on display brightness of the display. Furthermore, in this solution, a plurality of light-transmitting island structures arranged in an array are first formed through a patterning process, and an electrochromic material is then filled in a gap between the plurality of light-transmitting island structures arranged in the array, to form the electrochromic layer. In other words, there is no need to perform a patterning process on the electrochromic layer in this solution. This can prevent the patterning process from affecting electrochromic performance of the electrochromic layer, thereby ensuring better anti-peeping performance.

According to a third aspect, this application provides an electronic device, including a housing and the foregoing anti-peeping display, where the anti-peeping display is mounted to the housing.

The electronic device provided in this application includes the housing and the anti-peeping display. In the anti-peeping display prepared by the preparation method provided in embodiments of this application, the light-transmitting island structure above the pixel unit may allow small-angle light emitted by the pixel unit to pass through, and a voltage applied to the electrochromic layer is controlled to change transmittance of the electrochromic layer, so that the electrochromic layer can allow large-angle light emitted by the pixel unit to pass through, or absorb or reflect large-angle light emitted by the pixel unit. In this way, the anti-peeping display can switch between a shared display state and an anti-peeping display state. In addition, the entire anti-peeping structure is of small thickness, which can reduce impact on display brightness of the display. Furthermore, in this solution, the plurality of light-transmitting island structures arranged in the array are first formed through a patterning process, and the electrochromic material is then filled in the gap between the plurality of light-transmitting island structures arranged in the array, to form the electrochromic layer. In other words, there is no need to perform a patterning process on the electrochromic layer in this solution. This can prevent the patterning process from affecting electrochromic performance of the electrochromic layer, thereby ensuring better anti-peeping performance.

According to a fourth aspect, this application provides an anti-peeping method, applied to the foregoing electronic device. The method includes:
receiving an anti-peeping trigger instruction; and
controlling, according to the anti-peeping trigger instruction, a voltage applied to an electrochromic layer of the anti-peeping display, to change transmittance of the electrochromic layer.

The anti-peeping method provided in this application is applied to the electronic device with the anti-peeping display. The electronic device receives the anti-peeping trigger instruction, and controls a light transmission status of an anti-peeping layer in the anti-peeping display according to the received anti-peeping trigger instruction. After the anti-peeping trigger instruction is received, the voltage applied to the electrochromic layer is controlled. The voltage causes the electrochromic layer to change from a light-transmitting state to a non-light-transmitting state. The anti-peeping layer absorbs or reflects large-angle light emitted by a pixel and propagating toward a periphery of the anti-peeping display, causing the anti-peeping display to switch to an anti-peeping display state.

### BRIEF DESCRIPTION OF DRAWINGS

The accompanying drawings described herein are used to provide a further understanding of this application, and constitute a part of this application. Schematic embodiments of this application and descriptions thereof are used to explain this application, and do not constitute an undue limitation of this application. In the accompanying drawings:
FIG. 1 is a diagram of a structure of an electronic device according to an example embodiment of this application;
FIG. 2 is an exploded view of an electronic device according to an example embodiment of this application;
FIG. 3 is a schematic flowchart of a preparation method according to an example embodiment of this application;
FIG. 4 is a cross-sectional view of an anti-peeping display according to an example embodiment of this application;
FIG. 5 is an example diagram of an anti-peeping angle;
FIG. 6 is a partial cross-sectional view of an anti-peeping display according to an example embodiment of this application;
FIG. 7 to FIG. 11 are cross-sectional views of structures obtained through different preparation steps according to another embodiment of this application; and
FIG. 12 is a schematic flowchart of an anti-peeping method according to an example embodiment of this application.

### Reference numerals:

1: electronic device; 10: anti-peeping display; 20: housing; 201: middle frame; 202: rear cover; 2011: side frame portion; 2012: middle plate portion; 30: mainboard; 202: rear cover; 1011: substrate; 1014: thin film transistor layer; 1015: pixel define layer; 1012: pixel unit; 1013: first encapsulation layer; 106: raised layer; 1061: low-refractive-index material sublayer; 1062: high-refractive-index material sublayer; 104: first light-transmitting conductive layer; 102: electrochromic layer; 103: light-transmitting island structure; 105: second light-transmitting conductive layer; 107: second encapsulation layer; 108: touch layer; 109: light-transmitting adhesive layer; 110: cover glass; 110: reflective electrode.

### DESCRIPTION OF EMBODIMENTS

To make the objectives, technical solutions, and advantages of this application clearer, the following clearly and completely describes the technical solutions of this application with reference to specific embodiments of this application and corresponding accompanying drawings. It is clear that the described embodiments are merely some but not all of embodiments of this application. All other embodiments obtained by a person of ordinary skill in the art based on embodiments of this application without creative efforts shall fall within the protection scope of this application.

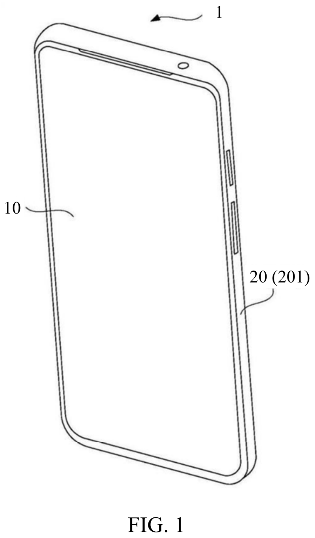

FIG. 1 is a diagram of a structure of an electronic device according to an embodiment of this application. As shown in FIG. 1, for example, an electronic device 1 is a mobile phone. The electronic device 1 may include an anti-peeping display 10 and a housing 20. The anti-peeping display 10 is configured to display an image. The housing 20 is configured to support, secure, and protect the anti-peeping display 10. It may be understood that the electronic device 1 in this embodiment of this application may alternatively be another electronic device such as a tablet computer, a notebook computer, a desktop computer, or an all-in-one computer, which is not limited in this embodiment.

In this embodiment, a surface that is of the electronic device 1 and that is for displaying an image is defined as the front of the electronic device 1, and another surface that is of the electronic device 1 and that is opposite to the front of the electronic device 1 is defined as the back of the electronic device 1. The front and the back of a related component of the electronic device 1 correspond to the front and the back of the electronic device 1. The front of the anti-peeping display 10, namely, a surface that is of the anti-peeping display 10 and that is for displaying an image, is exposed outside the housing 20, for user viewing or for performing an operation on the electronic device 1. The housing 20 encloses side walls and the back of the anti-peeping display 10, to support, secure, and protect the anti-peeping display 10.

The anti-peeping display 10 and the housing 20 together enclose an accommodating space of the electronic device 1, and other components of the electronic device 1 may be disposed in the accommodating space. For example, other components such as a mainboard, a speaker, a camera, a battery, and the like are disposed in the accommodating space.

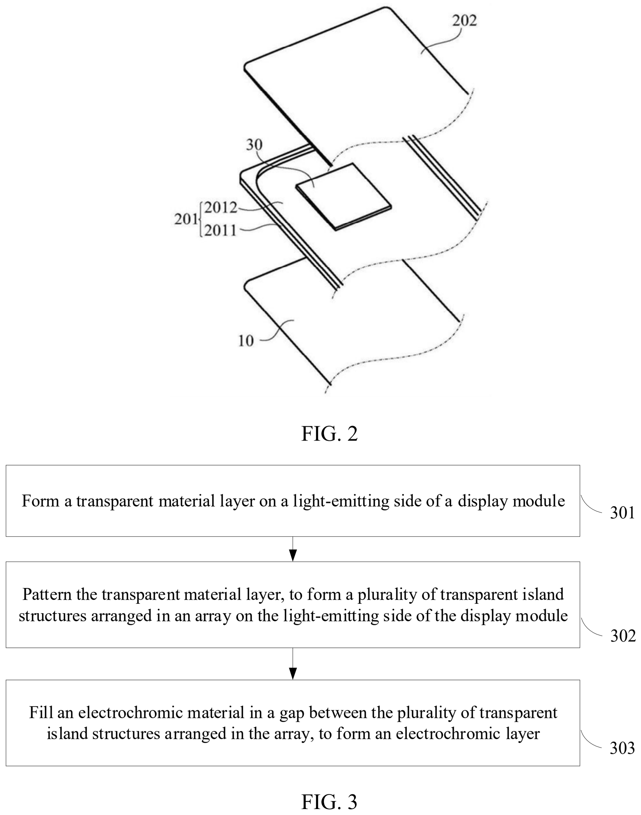

FIG. 2 is an exploded view of FIG. 1. As shown in FIG. 2, the housing 20 may include a middle frame 201 and a rear cover 202. The rear cover 202 may be a flat plate-shaped member. The rear cover 202 is located on the back of the electronic device 1. The middle frame 201 is connected between the anti-peeping display 10 and the rear cover 202. The middle frame 201 may include a side frame portion 2011 and a middle plate portion 2012. The side frame portion 2011 encloses a periphery of the electronic device 1. The middle plate portion 2012 is located in an area enclosed by the side frame portion 2011. An edge of the middle plate portion 2012 is connected to an inner side wall of the side frame portion 2011. For example, the middle plate portion 2012 and the side frame portion 2011 may be an integrally formed structure.

The anti-peeping display 10 is usually lapped over and supported on the middle plate portion 2012 of the middle frame 201, and the anti-peeping display 10 may be secured to a front end surface of the side frame portion 2011 of the middle frame 201 (an end surface that is of the side frame portion 2011 and that faces the front of the electronic device 1). An edge of the rear cover 202 may be secured to a rear end surface of the side frame portion 2011 of the middle frame 201 (an end surface that is of the side frame portion 2011 and that faces the back of the electronic device 1). A gap is formed between the middle plate portion 2012 of the middle frame 201 and the rear cover 202, and another component of the electronic device 1 may be disposed in the gap. For example, in FIG. 2, a mainboard 30 is attached to a surface that is of the middle plate portion 2012 and that faces the rear cover 202. In actual application, the mainboard 30 may be electrically connected to the anti-peeping display 10, and the anti-peeping display 10 is controlled through the mainboard 30 to display an image.

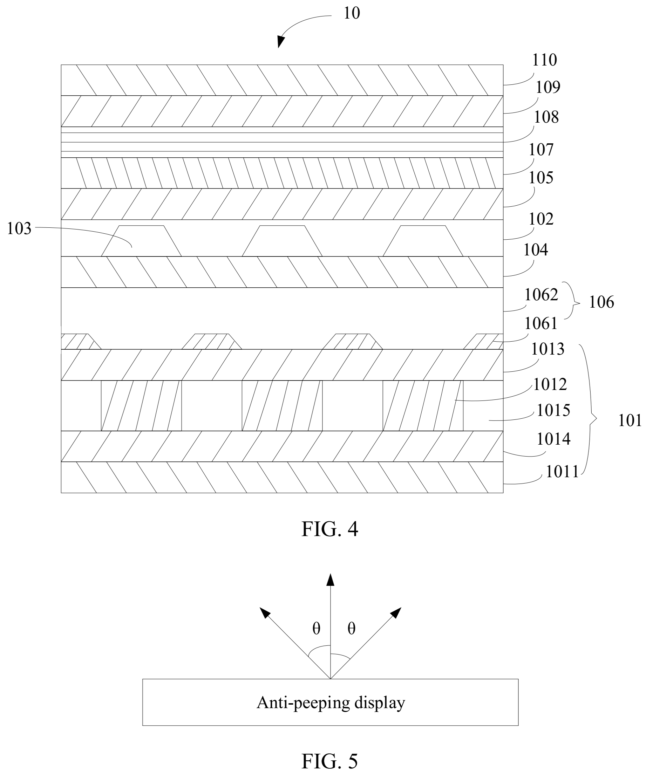

The following describes in detail a method for preparing the anti-peeping display, with reference to FIG. 3 and FIG. 4. As shown in FIG. 3, the preparation method may include the following steps.

301: Form a light-transmitting material layer on a light-emitting side of a display module.

The display module includes a substrate and a plurality of pixel units arranged in an array on the substrate.

302: Pattern the light-transmitting material layer, to form a plurality of light-transmitting island structures arranged in an array on the light-emitting side of the display module.

The plurality of light-transmitting island structures are in a one-to-one correspondence with the plurality of pixel units, and an orthographic projection of the light-transmitting island structure on the substrate covers an orthographic projection, of a pixel unit corresponding to the light-transmitting island structure, on the substrate.

303: Fill an electrochromic material in a gap between the plurality of light-transmitting island structures arranged in the array, to form an electrochromic layer.

The plurality of light-transmitting island structures are located in the electrochromic layer, and transmittance of the electrochromic layer changes in response to a voltage applied to the electrochromic layer.

FIG. 4 shows the anti-peeping display 10 prepared by the method for preparing the anti-peeping display 10 provided in embodiments of this application. As shown in FIG. 4, the anti-peeping display 10 includes a display module 101, an electrochromic layer 102 on a light-emitting side of the display module 101, and a plurality of light-transmitting island structures 103 arranged in an array in the electrochromic layer 102. The display module 101 includes a substrate 1011 and a plurality of pixel units 1012 arranged in an array on the substrate 1011. The plurality of light-transmitting island structures 103 are in a one-to-one correspondence with the plurality of pixel units 1012. An orthographic projection of the light-transmitting island structure 103 on the substrate 1011 coincides with an orthographic projection, of a pixel unit 1012 corresponding to the light-transmitting island structure 103, on the substrate 1011. Transmittance of the electrochromic layer 102 changes in response to a voltage applied to the electrochromic layer 102.

In 301, in actual application, the pixel unit 1012 corresponds to any one or any combination of a red sub-pixel (Red pixel), a green sub-pixel (Green pixel), and a blue sub-pixel (Blue pixel). In other words, the pixel unit 1012 may be a single sub-pixel, or may be a combined pixel of a plurality of sub-pixels, for example, an RGB pixel. In a specific example, for an anti-peeping display with an RGB display structure, the pixel unit 1012 refers to a single sub-pixel.

The plurality of pixel units are arranged in the array on the substrate. A specific arrangement of the plurality of pixel units may be specified according to an actual requirement. This is not specifically limited in embodiments of this application.

The substrate 1011 may include a glass substrate or a flexible substrate. A material of the flexible substrate may be selected according to an actual requirement. This is not specifically limited in embodiments of this application. In an example, the flexible substrate may be a colorless polyimide (Colorless Polyimide, CPI) substrate. The anti-peeping display can be foldable by using the flexible substrate.

In an example, the light-transmitting material layer allows light emitted by the display module to pass through. The light-transmitting material layer may be formed on the light-emitting side of the display module through coating. Specifically, a liquid containing a light-transmitting material may be coated on the light-emitting side of the display module 101 using a coating device, for example, a slot die coater, and subsequently dried to obtain the light-transmitting material layer.

In actual application, the light-transmitting material layer may be an organic coating (Organic Coating, OC) layer or a planarization layer (Planarization layer, PLN) layer.

In 302, the light-transmitting material layer may be patterned through an existing patterning process. In an example, the light-transmitting material layer may be etched through a photolithography process, to obtain the patterned light-transmitting material layer.

The patterned light-transmitting material layer includes the plurality of light-transmitting island structures 103 arranged in the array on the light-emitting side of the display module. The plurality of light-transmitting island structures 103 are in the one-to-one correspondence with the plurality of pixel units 1012. The orthographic projection of the light-transmitting island structure 103 on the substrate 1011 coincides with the orthographic projection, of the pixel unit 1012 corresponding to the light-transmitting island structure 103, on the substrate 1011. That is, an arrangement of the plurality of light-transmitting island structures 103 is the same as an arrangement of the plurality of pixel units 1012.

To avoid impact on display brightness of the display in a small-angle direction, there is a need to allow as much light as possible from the pixel unit in the small-angle direction to pass through. Therefore, in a specific example, the orthographic projection of the light-transmitting island structure 103 on the substrate 1011 covers the orthographic projection, of the pixel unit 1012 corresponding to the light-transmitting island structure 103, on the substrate 1011. As a result, the light emitted by the pixel unit 1012 in the small-angle direction can be all transmitted outward through the light-transmitting island structure 103. Further, to reserve more filling areas for the electrochromic material to improve anti-peeping effect, the orthographic projection of the light-transmitting island structure 103 on the substrate 1011 completely coincides with the orthographic projection, of the pixel unit 1012 corresponding to the light-transmitting island structure 103, on the substrate 1011.

In 303, the electrochromic material is filled, through a coating process or a printing process, in the gap between the plurality of light-transmitting island structures 103 arranged in the array. The printing process may include an inkjet printing process. In actual application, processes such as leveling and curing are further needed to finally form the electrochromic layer.

Optical properties (reflectivity, transmittance, absorptivity, and the like) of the electrochromic material may undergo stable and reversible changes under the action of an applied electric field, which are manifested as reversible changes in color and transparency in appearance. Electrochromic materials are classified into an inorganic electrochromic material and an organic electrochromic material. The inorganic electrochromic material is, for example, tungsten trioxide. The organic electrochromic material mainly includes polythiophenes and derivatives of the polythiophenes, viologens, tetrathiafulvalene, and metal phthalocyanines, and the like.

The plurality of light-transmitting island structures 103 are located in the electrochromic layer 102, and the transmittance of the electrochromic layer 102 changes in response to the voltage applied to the electrochromic layer 102. Specifically, the electrochromic layer 102 may complete switching between a light-transmitting state and a non-light-transmitting state in response to the voltage applied to the electrochromic layer 102. When the electrochromic layer 102 is in the light-transmitting state, the anti-peeping display 10 is in a shared display state. When the electrochromic layer 102 is in the non-light-transmitting state, the anti-peeping display 10 is in an anti-peeping display state.

In the anti-peeping display prepared by the preparation method provided in embodiments of this application, the light-transmitting island structure above the pixel unit may allow small-angle light emitted by the pixel unit to pass through, and the voltage applied to the electrochromic layer is controlled to change transmittance of the electrochromic layer, so that the electrochromic layer can allow large-angle light emitted by the pixel unit to pass through, or absorb or reflect large-angle light emitted by the pixel unit. In this way, the anti-peeping display can switch between the shared display state and the anti-peeping display state. In addition, the entire anti-peeping structure is of small thickness, which can reduce impact on the display brightness of the display. Furthermore, in this solution, the plurality of light-transmitting island structures arranged in the array are first formed through a patterning process, and the electrochromic material is then filled in the gap between the plurality of light-transmitting island structures arranged in the array, to form the electrochromic layer. In other words, there is no need to perform a patterning process on the electrochromic layer in this solution. This can prevent the patterning process from affecting electrochromic performance of the electrochromic layer, thereby ensuring better anti-peeping performance.

It should be noted that, generally, the transmittance of the electrochromic material changes through a redox reaction. If the electrochromic layer is directly patterned, a structure of the electrochromic material in the electrochromic layer is damaged, and consequently, the electrochromic material cannot undergo an effective redox reaction subsequently. This affects the anti-peeping effect or even leads to absence of an anti-peeping function.

In a feasible solution, the method may further include the following steps.

304: Form a first light-transmitting conductive layer on the light-emitting side of the display module before forming the light-transmitting material layer.

The light-transmitting material layer is formed on the first light-transmitting conductive layer.

305: Form a second light-transmitting conductive layer on the electrochromic layer.

The transmittance of the electrochromic layer changes in response to a voltage between the first light-transmitting conductive layer and the second light-transmitting conductive layer.

As shown in FIG. 4, the anti-peeping display 10 further includes: a first light-transmitting conductive layer 104 located between the display module 101 and the electrochromic layer 102, and a second light-transmitting conductive layer 105 located on a side that is of the electrochromic layer 102 and that is away from the display module 101.

The first light-transmitting conductive layer 104 and the second light-transmitting conductive layer 105 may both be ITO (Indium Tin Oxides, indium tin oxide) layers. In an example, neither the first light-transmitting conductive layer 104 nor the second light-transmitting conductive layer 105 has a hollow design.

In 304, in an example, before the light-transmitting material layer is formed, the first light-transmitting conductive layer 104 may be formed on the light-emitting side of the display module 101 through a PVD (Physical Vapor Deposition, physical vapor deposition) process, a coating process, or a printing process.

After the first light-transmitting conductive layer 104 is formed, the light-transmitting material layer is formed on the first light-transmitting conductive layer 104.

In 305, in an example, the second light-transmitting conductive layer 105 may be formed on the electrochromic layer 102 through a PVD process, a coating process, or a printing process.

As shown in FIG. 4, the first light-transmitting conductive layer 104, the electrochromic layer 102, and the second light-transmitting conductive layer 105 form a sandwich structure. It can be learned that in embodiments of this application, the anti-peeping structure is simple in structure and easy to manufacture.

In actual application, during filling of the electrochromic material in the gap between the plurality of light-transmitting island structures 103 arranged in the array, the electrochromic material is expected to be filled in only the gap and not deposited on top of the light-transmitting island structure 103. However, it is currently difficult for most coating devices or inkjet printers to ensure this. In other words, in the prepared anti-peeping display 10, there is a case in which the top of the light-transmitting island structure 103 is covered by the electrochromic material.

In actual application, a color-changing area of the electrochromic layer is only near a side surface in contact with one or two electrodes (which is usually a very thin area). To prevent the electrochromic material covering the top of the light-transmitting island structure 103 from blocking light in a small-angle direction, an appropriate electrochromic material may be selected based on an electrode type of the first light-transmitting conductive layer 104, so that a reversible change in transmittance (namely, color change) occurs only near a side surface that is of the electrochromic layer 102 and that is in contact with the first light-transmitting conductive layer. Specifically, when the first light-transmitting conductive layer 104 is used as an anode, the electrochromic material is an anodic electrochromic material; or when the first light-transmitting conductive layer 105 is used as a cathode, the electrochromic material is a cathodic electrochromic material.

When the first light-transmitting conductive layer 104 is used as an anode and the electrochromic material is an anodic electrochromic material, the color-changing area of the electrochromic layer 102 is only an area near the side surface that is of the electrochromic layer 102 and that is in contact with the first light-transmitting conductive layer. When the first light-transmitting conductive layer 104 is used as a cathode and the electrochromic material is a cathodic electrochromic material, the color-changing area of the electrochromic layer 102 is also only the area near the side surface that is of the electrochromic layer 102 and that is in contact with the first light-transmitting conductive layer. As a result, the electrochromic material covering the top of the light-transmitting island structure 103 does not undergo color change, and therefore does not block the light in the small-angle direction.

As shown in FIG. 5, an anti-peeping angle θ of the anti-peeping display is generally about 45 degrees. To reach a preset anti-peeping angle, there is a need to ensure a specific distance between the electrochromic layer 102 and a light-emitting surface of the pixel unit 1012. Therefore, the method may further include the following step.

306: Form a light-transmitting raised layer on the light-emitting side of the display module before forming the light-transmitting material layer.

As shown in FIG. 4, the anti-peeping display 10 may further include a light-transmitting raised layer 106 located between the display module 101 and the electrochromic layer 102. Specifically, the light-transmitting raised layer 106 is located between a first encapsulation layer 1013 of the display module 101 and the first transparent conductive layer 104.

In actual application, a thickness of the first encapsulation layer 1013 of the display module 101 and a thickness of the first transparent conductive layer 104 are very small, and may be ignored. Therefore, a numerical relationship between a height of the light-transmitting raised layer and a pixel width of the pixel unit is determined by the preset anti-peeping angle. For example, the height of the light-transmitting raised layer is greater than or equal to the pixel width of the pixel unit.

In 306, in an example, as shown in FIG. 4, the display module is an organic light-emitting diode OLED display module; the display module further includes the first encapsulation layer 1013 that covers the plurality of pixel units 1012. The first encapsulation layer 1013 may specifically be a thin film encapsulation (Thin Film Encapsulation, TFE) layer, and seals an OLED material by using an ultra-thin film, to protect the OLED material from erosion of external moisture and oxygen, thereby serving as an encapsulation material.

When the display module 101 is an OLED (Organic Light-Emitting Diode, organic light-emitting diode) display module, the raised layer 106 may be formed on the first encapsulation layer 1013 of the display module 101. A specific process may be selected according to an actual requirement. This is not specifically limited in embodiments of this application.

To further increase the display brightness of the display and reduce power consumption, light emitted by the pixel units may be converged. Specifically, the light-transmitting raised layer may be a microlens array (MLA, Microlens Array) layer. In a specific example, the microlens array layer may include a high-refractive-index material and a low-refractive-index material. Specifically, 306 "forming a light-transmitting raised layer on the light-emitting side of the display module before forming the light-transmitting material layer" may be implemented through the following steps.

3061: Form a low-refractive-index material sublayer on the light-emitting side of the display module before forming the light-transmitting material layer.

3062: Pattern the low-refractive-index material sublayer, to form a plurality of first openings arranged in an array in the low-refractive-index material sublayer.

The plurality of first openings are in a one-to-one correspondence with the plurality of pixel units, and an orthographic projection of the first opening on the substrate covers an orthographic projection, of a pixel unit corresponding to the first opening, on the substrate.

3063: Form a high-refractive-index material sublayer on the patterned low-refractive-index material sublayer.

The light-transmitting raised layer 106 consists of a patterned low-refractive-index material sublayer and a high-refractive-index material sublayer.

In 3061, specifically, the low-refractive-index material sublayer is formed on the first encapsulation layer 1013 of the display module 101.

In 3062, the low-refractive-index material sublayer may be patterned through an existing patterning process. In an example, the low-refractive-index material sublayer may be etched through a photolithography process, to form the plurality of first openings arranged in the array in the low-refractive-index material sublayer. The plurality of first openings are in the one-to-one correspondence with the plurality of pixel units, and the orthographic projection of the first opening on the substrate covers the orthographic projection, of the pixel unit corresponding to the first opening, on the substrate. In an example, the orthographic projection of the first opening on the substrate completely coincides with the orthographic projection, of the pixel unit corresponding to the first opening, on the substrate.

In 3063, the high-refractive-index material sublayer 1062 is formed on the patterned low-refractive-index material sublayer 1061.

In an example, the substrate 1011 is a flexible substrate, and the method further includes the following steps.

307: Form the display module on a glass carrier plate.

The flexible substrate is located on the glass substrate.

308: After preparation of each layer for the anti-peeping display is completed, peel off the peeling carrier plate through a peeling process, to expose the flexible substrate.

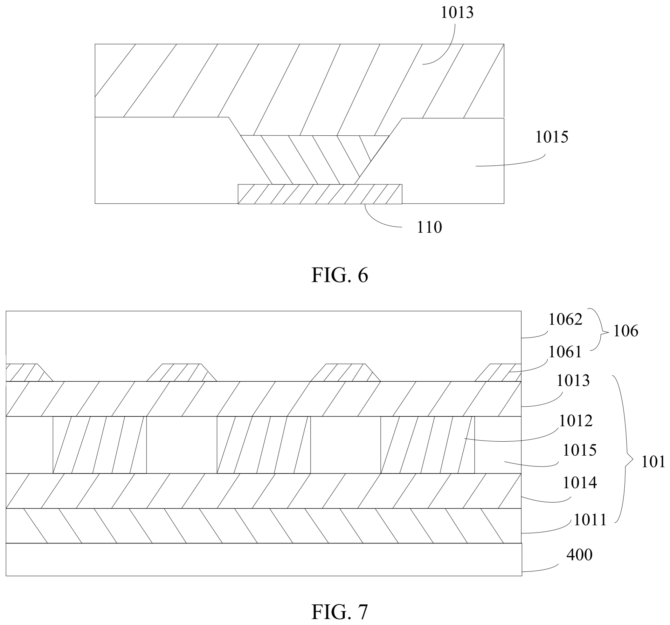

In 307, as shown in FIG. 7, the display module 101 is formed on a glass carrier plate 400. Specifically, the flexible substrate 1011 is formed on the glass substrate 400, and a thin film transistor (Thin Film Transistor, TFT) layer is formed on the flexible substrate 1011. Each pixel unit 1012 on the anti-peeping display 10 is driven by a thin film transistor integrated under the pixel unit. A pixel define layer (Pixel Define Layer, PDL) 1015 is formed on the thin film transistor layer 1014. Pixel units (namely, organic light-emitting diodes) are prepared in a plurality of light-emitting areas defined in the PDL layer, to obtain the plurality of pixel units 1012 arranged in the array. The first encapsulation layer 1013 covering the plurality of pixel units 1012 is prepared.

In this embodiment, each pixel unit on the anti-peeping display is driven by a thin film transistor integrated under the pixel unit, thereby implementing active driving.

To increase the display brightness of the display, as shown in FIG. 6, a first electrode 110 corresponding to the pixel unit 1012 is a reflective electrode (Reflective electrode, RE). The first electrode 110 is located on the back of the pixel unit 1012. The back of the pixel unit is opposite to the light-emitting surface of the pixel unit. The reflective electrode is used, so that light emitted from the back of the pixel unit can be reflected to the light-emitting surface of the pixel unit. This increases the display brightness of the display.

In 308, the peeling carrier plate may be peeled off through the peeling process, to expose the flexible substrate.

To improve an anti-peeping display with a touch function, the method may further include the following steps.

309: After the electrochromic layer is formed, form a second encapsulation layer on the light-emitting side of the display module.

310: Form a touch layer on the second encapsulation layer.

In 309, specifically, a second encapsulation layer 107 may be formed on the second light-transmitting conductive layer, to encapsulate a layer below the second encapsulation layer 107.

In 310, a touch (Touch Panel, TP) layer is formed on the second encapsulation layer 107. The touch layer may also be referred to as a TOE (TP On Encapsulation) layer.

The touch layer is classified as a capacitive component. The first light-transmitting conductive layer 104, the electrochromic layer 102, and the second light-transmitting conductive layer 105 also form a capacitive component. As shown in FIG. 4, the electrochromic layer 102 is located below the touch layer 108. This can prevent the capacitive structure formed by the first light-transmitting conductive layer 104, the electrochromic layer 102, and the second light-transmitting conductive layer 105 from affecting touch functionality of the touch layer.

In actual application, as shown in FIG. 4, after the touch layer 108 is formed, a cover glass (Cover Glass, CG) 110 may be adhered to the touch layer 108 through a light-transmitting adhesive layer 109, for example, an optical adhesive (Optically Clear Adhesive, OCA) layer.

In this embodiment of this application, an electrochromic anti-peeping structure is disposed above a light-emitting layer (namely, a layer in which plurality of pixel units 1012 are located) and below the touch layer, to implement four-sided peeping prevention and avoid interference to the touch layer. The light-emitting layer may be an electroluminescent (Electroluminescence, EL) layer.

It should be noted that, in addition to being the OLED display module, the display module 101 may be an LCD (Liquid Crystal Display, liquid crystal display) display module. When the display module 101 is an LCD display module, the raised layer 106 may be formed on a first cover of the LCD display module.

In conclusion, an in-cell (In-cell) active anti-peeping display with better anti-peeping effect can be prepared by the preparation method provided in embodiments of this application.

The following describes, by using examples, the preparation method provided in embodiments of this application with reference to FIG. 7, FIG. 8, FIG. 9, FIG. 10, and FIG. 11.

After preparation of a TFT layer 1014, a PLD layer 1015, a plurality of pixel units 1012, and a TFE layer 1013 on an OLED panel that includes a CPI flexible substrate and a glass carrier plate is completed, the following steps are performed.

Step 1: Print a high-refractive-index material and a low-refractive-index material on the TFT layer 1013, to obtain a raised layer 106.

After step 1, a structure shown in FIG. 7 is obtained.

Step 2: Deposit a first light-transmitting conductive layer 104 on the raised layer 106 through a PVD process, a coating device, or an IJP (Inkjet Printer, inkjet printer), and then fabricate a plurality of light-transmitting island structures 103 arranged in an array on the first light-transmitting conductive layer 104.

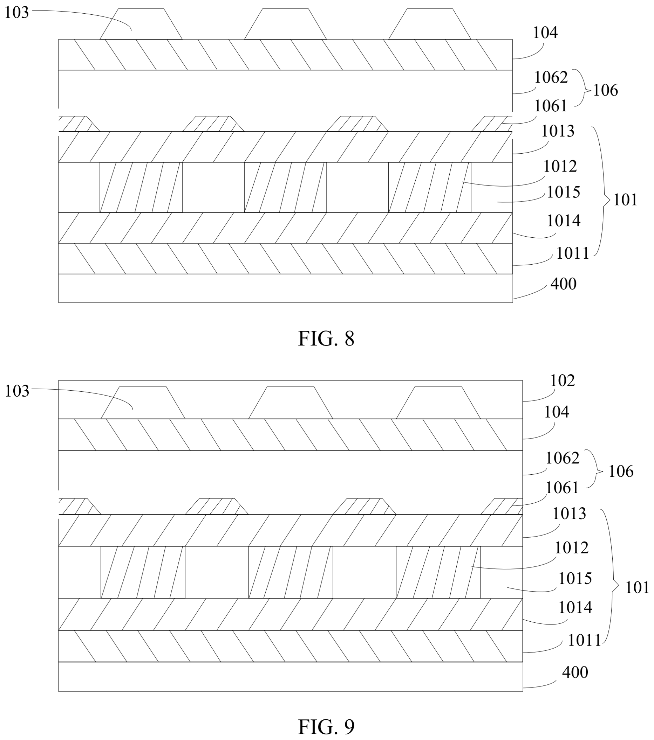

After step 2, a structure shown in FIG. 8 is obtained.

Step 3: Coat an electrochromic material through an IJP device or a PHOTO-line device, and level and cure the electrochromic material, to obtain an electrochromic layer 102.

After step 3, a structure shown in FIG. 9 is obtained.

Step 4: Deposit a second light-transmitting conductive layer 105 on the raised layer 106 through a PVD process, a coating device, or an IJP (Inkjet Printer, inkjet printer).

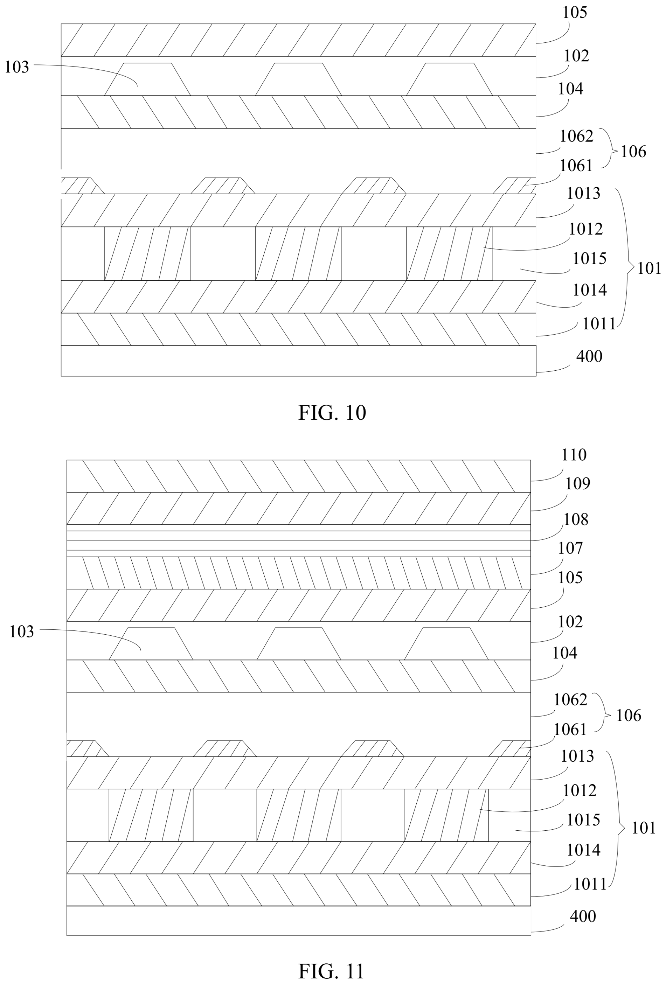

After step 4, a structure shown in FIG. 10 is obtained.

Step 5: Finally complete preparation of a second TFE layer 107, a TOE layer 108, an OCA layer 109, and a CG layer 110.

After step 5, a structure shown in FIG. 11 is obtained.

After step 5, a glass carrier plate 400 in FIG. 11 may be peeled off through a peeling process, to obtain the final anti-peeping display 10 shown in FIG. 4.

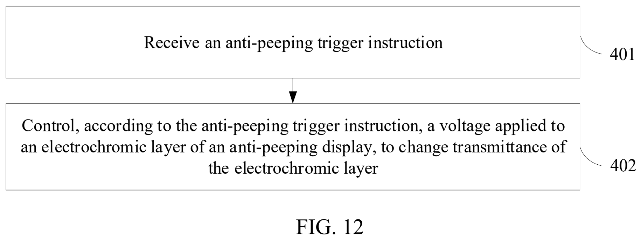

Based on this, an embodiment of this application further provides an anti-peeping method. The anti-peeping method is applied to the foregoing electronic device 1 with the anti-peeping display 10. FIG. 12 is a flowchart of steps of an anti-peeping method according to an embodiment of this application. As shown in FIG. 12, the anti-peeping method includes the following steps.

401: Receive an anti-peeping trigger instruction.

402: Control, according to the anti-peeping trigger instruction, a voltage applied to the electrochromic layer of the anti-peeping display, to change transmittance of the electrochromic layer.

In 401, the electronic device 1 receives the anti-peeping trigger instruction. For example, a controller disposed in the electronic device 1 may receive the anti-peeping trigger instruction. In actual application, in a normal case, the first light-transmitting conductive layer 104 and the second light-transmitting conductive layer 105 may be not energized, the electrochromic layer 102 is in a light-transmitting state, and the anti-peeping display 10 is in a shared display state. When receiving the anti-peeping trigger instruction, the controller controls the first light-transmitting conductive layer 104 and the second light-transmitting conductive layer 105 to be energized, the electrochromic layer 102 to change to a non-light-transmitting state, and the anti-peeping display 10 to switch to an anti-peeping display state.

For example, the controller may be a chip such as a drive chip or a power chip in the electronic device 1, and the first light-transmitting conductive layer 104 and the second light-transmitting conductive layer 105 are electrically connected to the chip. Alternatively, a dedicated controller may be disposed to control an energization status of the first light-transmitting conductive layer 104 and the second light-transmitting conductive layer 105.

In 402, the voltage between the first light-transmitting conductive layer 104 and the second light-transmitting conductive layer 105 of the anti-peeping display is controlled according to the anti-peeping trigger instruction, so that the electrochromic layer in the anti-peeping layer is in a non-light-transmitting state.

After receiving the anti-peeping trigger instruction, the controller in the electronic device 1 controls, according to the anti-peeping trigger instruction, the first light-transmitting conductive layer 104 and the second light-transmitting conductive layer 105 to be energized, to form an electric field in the electrochromic layer 102; and controls the voltage between the first light-transmitting conductive layer 104 and the second light-transmitting conductive layer 105, to cause the electrochromic layer 102 to change from the light-transmitting state to the non-light-transmitting state and cause the anti-peeping display 10 to switch to the anti-peeping display state.

The anti-peeping method provided in this application is applied to the electronic device with the anti-peeping display. The electronic device receives the anti-peeping trigger instruction, and controls a light transmission status of an anti-peeping layer in the anti-peeping display according to the received anti-peeping trigger instruction. After the anti-peeping trigger instruction is received, the voltage applied to the electrochromic layer is controlled. The voltage causes the electrochromic layer to change from a light-transmitting state to a non-light-transmitting state. The anti-peeping layer absorbs or reflects large-angle light emitted by a pixel and propagating toward a periphery of the anti-peeping display, causing the anti-peeping display to switch to an anti-peeping display state.

It should be further noted that, the term "include", "comprise", or any other variant thereof is intended to cover a non-exclusive inclusion, so that a process, a method, an article, or a device that includes a series of elements not only includes those elements but also includes other elements that are not expressly listed, or further includes elements inherent to such a process, method, article, or device. An element preceded by "includes a ..." does not, without more constraints, preclude the existence of additional identical elements in the process, method, article, or device that includes the element.

The foregoing descriptions are merely embodiments of this application, and are not intended to limit this application. A person skilled in the art may make various modifications and variations to this application. Any modification, equivalent replacement, improvement, or the like made without departing from the spirit and principle of this application shall fall within the scope defined by the claims of this application.

## Claims

1. A method for preparing an anti-peeping display, comprising:
forming a light-transmitting material layer on a light-emitting side of a display module, wherein the display module comprises a substrate and a plurality of pixel units arranged in an array on the substrate;
patterning the light-transmitting material layer, to form a plurality of light-transmitting island structures arranged in an array on the light-emitting side of the display module, wherein the plurality of light-transmitting island structures are in a one-to-one correspondence with the plurality of pixel units, and an orthographic projection of the light-transmitting island structure on the substrate coincides with an orthographic projection, of a pixel unit corresponding to the light-transmitting island structure, on the substrate; and
filling an electrochromic material in a gap between the plurality of light-transmitting island structures arranged in the array, to form an electrochromic layer, wherein the plurality of light-transmitting island structures are located in the electrochromic layer, and transmittance of the electrochromic layer changes in response to a voltage applied to the electrochromic layer.

2. The method according to claim 1, further comprising:
forming a first light-transmitting conductive layer on the light-emitting side of the display module before forming the light-transmitting material layer, wherein the light-transmitting material layer is formed on the first light-transmitting conductive layer; and
forming a second light-transmitting conductive layer on the electrochromic layer, wherein
the transmittance of the electrochromic layer changes in response to a voltage between the first light-transmitting conductive layer and the second light-transmitting conductive layer.

3. The method according to claim 2, wherein when the first light-transmitting conductive layer is used as an anode, the electrochromic material is an anodic electrochromic material; or
when the first light-transmitting conductive layer is used as a cathode, the electrochromic material is a cathodic electrochromic material.

4. The method according to any one of claims 1 to 3, wherein the orthographic projection of the light-transmitting island structure on the substrate covers the orthographic projection, of the pixel unit corresponding to the light-transmitting island structure, on the substrate.

5. The method according to any one of claims 1 to 3, further comprising:
forming a light-transmitting raised layer on the light-emitting side of the display module before forming the light-transmitting material layer.

6. The method according to claim 5, wherein a numerical relationship between a thickness of the light-transmitting raised layer and a pixel width of the pixel unit is determined by a preset anti-peeping angle.

7. The method according to claim 5, wherein the forming a light-transmitting raised layer on the light-emitting side of the display module before forming the light-transmitting material layer comprises:
forming a low-refractive-index material sublayer on the light-emitting side of the display module before forming the light-transmitting material layer;
patterning the low-refractive-index material sublayer, to form a plurality of first openings arranged in an array in the low-refractive-index material sublayer, wherein the plurality of first openings are in a one-to-one correspondence with the plurality of pixel units, and an orthographic projection of the first opening on the substrate covers an orthographic projection, of a pixel unit corresponding to the first opening, on the substrate; and
forming a high-refractive-index material sublayer on the patterned low-refractive-index material sublayer, wherein the light-transmitting raised layer comprises the patterned low-refractive-index material sublayer and the high-refractive-index material sublayer.

8. The method according to any one of claims 1 to 3, wherein the display module is an organic light-emitting diode OLED display module; and
the OLED display module further comprises a first encapsulation layer that covers the plurality of pixel units.

9. The method according to claim 8, wherein the substrate is a flexible substrate, and the method further comprises:
forming the display module on a glass carrier plate, wherein the flexible substrate is located on the glass substrate; and
after preparation of each layer for the anti-peeping display is completed, peeling off the peeling carrier plate through a peeling process, to expose the flexible substrate.

10. The method according to any one of claims 1 to 3, wherein the filling an electrochromic material in a gap between the plurality of light-transmitting island structures arranged in the array comprises:
filling, through a coating process or a printing process, the electrochromic material in the gap between the plurality of light-transmitting island structures arranged in the array.

11. The method according to any one of claims 1 to 3, further comprising:
after the electrochromic layer is formed, forming a second encapsulation layer on the light-emitting side of the display module; and
forming a touch layer on the second encapsulation layer.

12. An anti-peeping display, wherein the anti-peeping display is prepared by the preparation method according to any one of claims 1 to 11.

13. An electronic device, comprising a housing and the anti-peeping display according to claim 12, wherein the anti-peeping display is mounted to the housing.

14. An anti-peeping method, applied to the electronic device according to claim 13, wherein the method comprises:
receiving an anti-peeping trigger instruction; and
controlling, according to the anti-peeping trigger instruction, a voltage applied to an electrochromic layer of the anti-peeping display, to change transmittance of the electrochromic layer.
